# EUROPÄISCHE PATENTSCHRIFT

(11) **EP 1 705 163 B1**
(45) Veröffentlichungstag und Bekanntmachung des Hinweises auf die Patenterteilung: **11.05.2011**
(21) Anmeldenummer: 06005899.7
(22) Anmeldetag: 22.03.2006
(51) Int. Cl.: C03C 17/34, C03C 17/02, C04B 41/90

(54) **Bedienpanel**
Control panel
Tableau de commande

(30) Priorität: 24.03.2005 DE 102005013884
(43) Veröffentlichungstag der Anmeldung: 27.09.2006
(73) Patentinhaber: Irlbacher Blickpunkt Glas GmbH, 92539 Schoensee (DE)
(72) Erfinder: Irlbacher, Günther, 92539 Schönsee (DE)
(74) Vertreter: Hinkelmann, Klaus

(56) Entgegenhaltungen:
- EP-A- 0 345 993
- EP-A- 0 723 941
- US-A- 4 855 550
- US-A- 4 975 301
- US-A- 5 300 349
- US-A- 5 610 380
- US-B1- 6 265 682

## Beschreibung

Die Erfindung betrifft ein Bedienpanel mit einem planen oder gebogenen Basiskörper aus einem dielektrischen Werkstoff wie Glas, Glaskeramik oder Keramik, der rückseitig mit mindestens einer Schicht aus einbrennbarer Farbe, wie Email- oder Keramikfarbe, und mindestens einer Schicht von Leiterstrukturen aus einbrennbarer Leitpaste bedruckt ist, und wobei die Leiterstrukturen zur Aufnahme von mindestens einem elektronischen Bauteil ausgebildet sind.

Derartige Bedienpanels werden schon seit längerem, z.B. als Konsolen von Haushaltsgeräten wie Spülmaschinen oder Herden eingesetzt. Aufgrund der leichten Reinigbarkeit, alle elektronischen Bauteile und weiteren Komponenten oder Anschlüsse befinden sich auf der Rückseite des Bedienpanels, kommen diese Bedienpanels auch im Labor- bzw. Medizintechnikbereich zum Einsatz.

So ist aus der DE 102 24 537 A1 ein Bedienpanel in Form einer Tastatureinrichtung und ein Verfahren zur Herstellung einer solchen Tastatureinrichtung bekannt. Die Tastatureinrichtung umfasst dabei eine transparente Frontplatte z.B. aus Glas, auf deren Rückseite ein Farbaufdruck aufgebracht ist. Das Bedrucken der Glasscheibe erfolgt beispielsweise mit Siebdrucktechnik. Ist die Glasplatte zu glatt, so wird sie gegebenenfalls vor dem Bedrucken aufgeraut. Auf den Farbaufdruck wird ein Haftmittel, beispielsweise ein Harz, in zwei Schichten aufgebracht. Falls auch die Farbschicht zu glatt ist, wird sie ebenfalls vor dem Aufbringen der Haftschicht aufgeraut. Auf der zweiten Haftschicht befindet sich eine Leiterschicht, z.B. aus Kupfer. Diese Schicht wird anschließend, z.B. mittels Fototechnik und Ätzverfahren, strukturiert, so dass Leiterbahnen entstehen. Die Fertigung der Tastatureinrichtung erfolgt im Nutzen, d.h. es wird eine große Glasplatte, bestehend aus mehreren einzelnen Frontplatten, mit dem obigen Fertigungsverfahren produziert und nach dem Ätzen in die einzelnen Tastatureinrichtungen zerteilt. Im Anschluss daran erfolgt das Auflöten von elektronischen Bauteilen auf die einzelnen Platten. Durch die zahlreichen Arbeitsgänge ist das oben beschriebene Verfahren zur Fertigung der Tastatureinrichtungen relativ kostspielig.

Auch aus der EP 624 279 B1 ist ein auf Berührung ansprechende Bedienungsfeld bzw. eine Steuertafel bekannt. Die Steuertafel umfasst eine Vorderplatte aus dielektrischem Material, wie z.B. Glas, und direkt auf der Vorderplatte angebrachte Leiter- und Elektrodenbereiche.

Die leitenden Streifen und Bereiche können aus einer Silberverbindung bestehen, die mittels Siebdruck aufgebracht wird. Gegebenenfalls kann darauf noch eine Überzugsschicht angebracht werden. Es wird auch beschrieben, dass zwischen den leitenden Bereichen und der Glasplatte eine Unterbeschichtungsschicht aus Farbe aufgebracht wird.

Ein weiteres gattungsgemäßes Bedienpanel bzw. eine Sensorvorrichtung ist aus der DE 201 19 700 U1 bekannt. Die Sensorvorrichtung umfasst eine Blende, auf der Dekor- oder Farbschichten im Siebdruckverfahren aufgedruckt werden können. Auf diesen Farbschichten oder auch direkt auf die Blende wird ein Sensorelement ebenfalls im Siebdruckverfahren aufgedruckt. Als Material für das Sensorelement kann beispielsweise eine Art Emaillack aus Glaspartikeln und Silberpartikeln verwendet werden. Nach dem Auftragen der einzelnen Schichten wird der Lack pro Lackschicht eingebrannt. Das Sensorelement ist leitend mit einer Steuerung verbunden.

Die US 5,610,380 beschreibt ein berührungsempfindliches Bedienpanel, bei dem mindestens eine Leiterstruktur, jede leitfähige Schicht und die Mehrzahl von Elektroden in direktem Kontakt mit der Rückseite einer vorzugsweise aus einem dielektrischen Material wie Glas bestehenden Platte sind. Allerdings zeigt Fig. 3, dass sich zwischen der Leiterstruktur und der Rückseite der Glasplatte eine Zwischenschicht befinden kann, welche dem Glas eine Farbe verleihen kann, aber auch als Basis für ein nachfolgendes Bedrucken mit leitenden Streifen und Flächen dienen kann.

Die US 5,300,349 beschreibt Glasformkörper, die mit elektrischen Streifenleitern ausgerüstet sind, die ein farbiges Aussehen haben, wenn sie durch das Glas betrachtet werden; insbesondere die hinteren Glasfenster bei Automobilen. In den Glosformkörpern ist daher eine im Wesentlichen aus anorganischem Pigment gebildete Schicht vorhanden, die auf der Oberfläche des Glasformkörpers angeordnet ist, und eine Schicht von leitfähigem Material, welche über Haftbrücken aus einem verglasenden Material mit dem Glasformkörper verbunden ist.

Nachteilig bei allen diesen Bedienpanelen ist jedoch, dass die Herstellverfahren sehr aufwändig sind und viele Schritte umfassen. Dadurch fallen höhere Herstellkosten an, als notwendig wäre.

Es ist daher die Aufgabe der vorliegenden Erfindung, ein kostengünstigeres Bedienpanel bereit zu stellen, das eine vereinfachte Herstellung mit weniger Arbeitsschritten zulässt.

Hierzu ist erfindungsgemäß vorgesehen, dass mehrere Schichten aus ein brennbarer Farbe auf dem Basiskörper angebracht sind, das Bedienpanel erhältlich ist durch Einbrennen der Farbe und der Leitpaste in einem Arbeitsgang, wobei die Farbe und die Leitpaste im Wesentlichen die gleiche Einbrenntemperatur haben, und die Leiterstrukturen mindestens ein Sensorelement umfassen. Dadurch ist es möglich, den Herstellprozess zu verkürzen und so Zeit einzusparen, Energieverbrauch und Kosten zu verringem.

In einer Ausführungsform liegt die Einbrenntemperatur der Farbe und der Leitpaste dabei im Bereich von 600 bis 700 °C. Durch das Einbrennen verbinden sich die Farb- und die Leiterstrukturschichten fest mit dem Material des Basiskörpers. So wird eine kratzfeste Oberfläche erreicht. Außerdem sind die Glasemailfarben UV-beständig und temperaturbeständig, so dass auch ein Einsatz z.B. im Außenbereich möglich ist.

Zweckmäßigerweise kann die Einbrenntemperatur der Farben und der Leitpaste etwa 620 °C betragen. Bei dieser Temperatur wird eine besonders feste Verbindung zwischen den Farb- und Leiterstrukturschichten erzielt.

Bei einer weiteren vorteilhaften Ausführungsform der vorliegenden Erfindung ist vorgesehen, dass der plane oder gebogene Basiskörper aus Einscheibensicherheitsglas besteht. Somit ist der Basiskörper besonders bruchfest und auch bei hohen Temperaturen noch stabil.

In einer weiteren Variante ist vorgesehen, dass mindestens ein elektronisches Bauteil auf der Rückseite des planen oder gebogenen Basiskörpers befestigt ist. Die Anbindung kann beispielsweise mittels Löttechnik erfolgen. Eine zusätzliche Leiterplatte für elektronische Bauteile wird somit nicht benötigt.

Darüber hinaus besteht auch die Möglichkeit, dass die Leiterstrukturen mindestens eine elektronische Komponente wie Widerstände umfassen. Die Widerstände müssen somit nicht in einem zusätzlichen Verfahrensschritt an die Leiterstrukturen angelötet werden.

Darüber hinaus bezieht sich die Erfindung auch auf ein Verfahren zur Herstellung eines Bedienpaneles. Das Verfahren umfasst folgende Schritte:
- Bereitstellen eines planen oder gebogenen Basiskörpers aus einem dielektrischen Werkstoff wie Glas, Glaskeramik oder Keramik,
- Aufbringen vor mehreren Schichten aus einbrennbarer Farbe, wie Keramikfarbe oder Glasemailfarbe, auf die Rückseite des planen oder gebogenen Basiskörpers,
- Aufbringen mindestens einer Schicht von Leiterstrukturen aus einer einbrennbaren Leitpaste auf die Rückseite des planen oder gebogenen Basiskörpers oder die Farbe, wobei die Farbe und die Leitpaste im Wesentlichen die gleiche Einbrenntemperatur haben und die Leiterstrukturen mindestens ein Sensorelement umfassen und zur Aufnahme von mindestens einem elektronischen Bauteil ausgebildet sind,
- Einbrennen der Farbschichten und der Leiterstrukturen in einem Arbeitsgang.

Das Verfahren hat den Vorteil, dass das Einbrennen aller Farb- und Leiterstrukturschichten in einem Arbeitsgang erfolgt, und somit Energie, Zeit und Kosten eingespart werden können. Zudem ist der bedruckte Basiskörper sofort nach dem Einbrennen bestückungsfähig, da kein aufwändiges Verfahren zur Strukturierung der Leiterbahnen notwendig ist.

In einer bevorzugten Ausgestaltung erfolgt das Einbrennen der Farbdekors und der Leiterstrukturen in einem Temperaturbereich von 600 bis 700 °C. Das Verfahren hat entsprechend den Vorteil, dass sich die Farben und die Leiterbahnstrukturen fest mit dem Basiskörper verbinden und so eine besonders kratzfeste Oberfläche erzielt wird.

In einer besonders bevorzugten Variante erfolgt das Einbrennen bei 620 °C. Damit wird eine besonders feste Verbindung zwischen dem Material des Basiskörpers und den Beschichtungen erzielt.

Gemäß einer weiteren Ausführungsform ist vorgesehen, dass das Aufbringen der Farben und der Leiterstrukturen im Siebdruckverfahren erfolgt. Mittels Siebdruck können auch unebene Flächen bedruckt werden. Zudem kann die Farbschichtdicke genau bestimmt werden.

In einer weiteren Variante erfolgt jeweils ein Zwischentrocknungsschritt nach dem Aufbringen der mindestens einen Farb- bzw. Leitpastenschichten. Damit wird erreicht, dass keine Vermischung zwischen den einzelnen Schichten stattfindet. Das Zwischentrocknen erfolgt bevorzugt bei Temperaturen von 100 bis 150 °C.

Weiterhin ist es möglich, dass nach dem Einbrennen der Farb- und Leiterstrukturschichten elektronische Bauteile in einem weiteren Schritt auf der Rückseite des Basiskörpers angebracht werden. Die Anbringung kann beispielsweise mittels Löttechnik erfolgen. Somit wird keine weitere Leiterplatte für elektronische Komponenten benötigt.

Im Folgenden wird eine Ausführungsform der Erfindung anhand einer Zeichnung näher erläutert. Es zeigen:
- Fig. 1: Draufsicht auf ein Bedienelement,
- Fig. 2: Querschnitt durch das in Fig. 1 gezeigte Bedienelement.

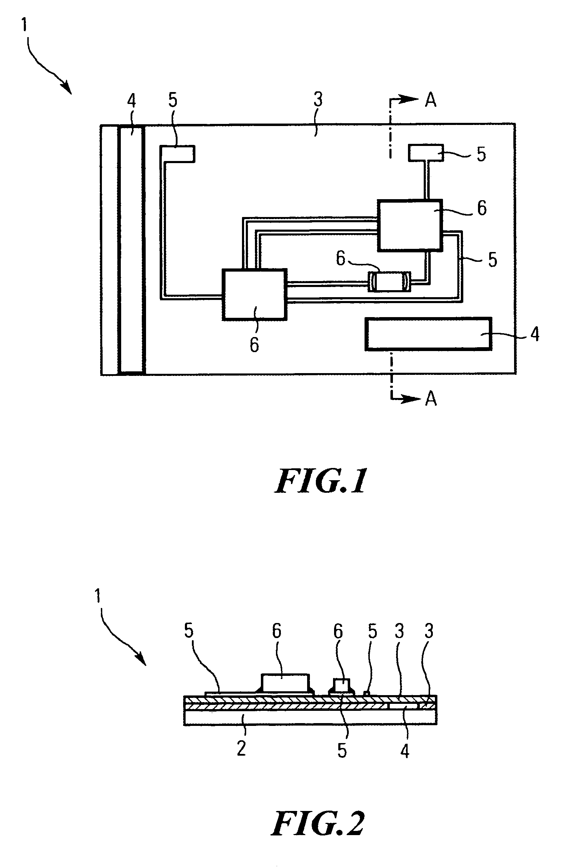

In Fig. 1 ist ein Bedienpanel 1 mit einem planen Basiskörper 2 gezeigt. Es wäre aber auch möglich, einen gebogenen Basiskörper einzusetzen. Der Basiskörper 2 besteht aus einem dielektrischen Material, wie z.B. Glas, Glaskeramik oder Keramik. Bevorzugt wird transparentes oder semitransparentes Material verwendet, so dass ein rückseitiger Farbaufdruck erkennbar ist. Besonders bevorzugt wird bruchfestes und temperaturstabiles Einscheibensicherheitsglas eingesetzt. Auf den Basiskörper 2 wird im Siebdruckverfahren mindestens eine Farbschicht 3 aufgebracht. Dafür werden z.B. einbrennbare Glasemail- oder Keramikfarben verwendet.

Die Farbschichten 3 können auch Aussparungen 4 aufweisen, bzw. nur kleine Abschnitte des Basiskörpers 2 bedecken. Die Gesamtdicke der Farbschichten 3 muss also nicht über den Basiskörper 2 gleich sein.

Auf den Farbschichten 3 bzw. direkt auf dem Basiskörper 2 sind Leiterstrukturen 5 aufgebracht. Die Leiterstrukturen 5 bestehen bevorzugt aus einbrennbarer Silberleitpaste. Es ist auch denkbar, dass die Leiterstrukturen 5 elektronische Komponenten wie Widerstände oder Sensorelemente umfassen. Das Aufbringen der Leiterstrukturen 5 kann ebenfalls im Siebdruckverfahren erfolgen. Nach dem Aufbringen aller Farb- 3 und Leiterstrukturschichten 5 erfolgt das Einbrennen in einem Schritt. Die Einbrenntemperatur liegt im Bereich von 600 bis 700 °C und beträgt vorzugsweise etwa 620 °C.

Auf den Leiterstrukturen 5 können weitere elektronische Bauteile 6 aufgebracht werden, beispielsweise mittels Löttechnik, so dass der fertiggestellte Basiskörper 2 eine integrierte Schaltung darstellt.

Alle Beschichtungen und weitere Komponenten wie elektronische Bauteile oder Anschlüsse sind auf der Rückseite des Basiskörpers 2 angebracht, so dass die Vorderseite eine geschlossene Oberfläche bildet.

In Fig. 2 ist ein Querschnitt durch das in Fig. 1 dargestellte Bedienpanel 1 gezeigt. In dieser Darstellung ist der Aufbau der einzelnen Farb- 3 und Leiterstrukturschichten 5 gut erkennbar. Die Vorderseite des Bedienpanels 1 wird durch den Basiskörper 2 gebildet. Auf der Rückseite des Basiskörpers 2 werden die Farbschichten 3 aufgebracht, die Aussparungen 4 aufweisen können. Auf den Farbschichten 3 befinden sich die Leiterstrukturschichten 5. An den Leiterstrukturschichten 5 können weitere elektronische Bauteile 6 angebracht werden, z.B. durch Lötverbindungen.

Anhand der Fig. 2 wird im Folgenden auch das Verfahren zur Herstellung eines Bedienpanels 1 näher erläutert.

In einem ersten Schritt wird der Basiskörper 2 bereitgestellt. Im Anschluss daran werden Schichten aus einbrennbarer Farbe 3 wie Keramik- oder Glasemailfarbe im Siebdruckverfahren auf die Rückseite des Basiskörpers 2 aufgebracht. Dabei ist es möglich, dass bestimmte Bereiche der Rückseite des Basiskörpers 2 nicht mit Farbe bedeckt werden.

Gegebenenfalls erfolgt nach dem Aufbringen einer Farbschicht bzw. aller Farbschichten ein Zwischentrockenschritt bei etwa 100 bis 150 °C.

Danach wird mindestens eine Schicht von Leiterstrukturen aus einbrennbarer Leitpaste 5 auf die Rückseite des Basiskörpers 2 oder auf die Farbe 3 aufgetragen. Das Aufbringen der Leiterstrukturen aus einbrennbarer Leitpaste 5 kann ebenfalls im Siebdruckverfahren erfolgen.

Nach dem Aufbringen aller Farbschichten 3 und Leiterstrukturschichten 5 erfolgt das Einbrennen dieser Schichten in einem Schritt. Die Einbrenntemperatur liegt dabei im Bereich von 600 bis 700 °C und beträgt vorzugsweise etwa 620 °C.

Die so hergestellte Leiterplatte ist direkt nach dem Einbrennen bestückungsfähig, so dass auf die Leiterstrukturen 5 weitere elektronische Bauteile 6 z.B. mittels eines Lötverfahrens, aufgebracht werden können.

## Patentansprüche

1. Bedienpanel (1) mit einem planen oder gebogenen Basiskörper (2) aus einem dielektrischen Werkstoff wie Glas, Glaskeramik oder Keramik, der rückseitig mit mindestens einer Schicht aus einbrennbarer Farbe (3), wie Glasemail- oder Keramikfarbe und mindestens einer Schicht von Leiterstrukturen (5) aus einbrennbarer Leitpaste bedruckt ist, wobei die Leiterstrukturen (5) zur Aufnahme von mindestens einem elektronischen Bauteil (6) ausgebildet sind, **dadurch gekennzeichnet, dass** mehrere Schichten aus einbrennbarer Farbe auf dem Basiskörper (2) angebracht sind, das Bedienpanel (1) erhältlich ist durch Einbrennen der Farbe (3) und der Leitpaste (5) in einem Arbeitsgang, wobei die Farbe (3) und die Leitpaste (5) im Wesentlichen die gleiche Einbrenntemperatur haben, und die Leiterstrukturen (5) mindestens ein Sensorelement umfassen.

2. Bedienpanel (1) nach Anspruch 1, **dadurch gekennzeichnet, dass** die Einbrenntemperatur der Farbe (3) und der Leitpaste (5) im Bereich von 600 bis 700 °C liegt.

3. Bedienpanel (1) nach einem der Ansprüche 1 oder 2, **dadurch gekennzeichnet, dass** die Einbrenntemperatur der Farbe (3) und der Leitpaste (5) etwa 620 °C beträgt.

4. Bedienpanel (1) nach einem der Ansprüche 1 bis 3, **dadurch gekennzeichnet, dass** der Basiskörper (2) aus Einscheibensicherheitsglas besteht.

5. Bedienpanel (1) nach einem der Ansprüche 1 bis 4, **dadurch gekennzeichnet, dass** mindestens ein elektronisches Bauteil (6) auf der Rückseite des Basiskörpers (2) befestigt ist.

6. Bedienpanel (1) nach einem der Ansprüche 1 bis 5, **dadurch gekennzeichnet, dass** die Leiterstrukturen (5) mindestens eine elektronische Komponente wie Widerstände umfassen.

7. Bedienpanel (1) nach einem der Ansprüche 1 bis 6, **dadurch gekennzeichnet, dass** das Bedienpanel (1) erhältlich ist durch ein Verfahren, das vor dem Einbrennen von mindestens einer Farbschicht (3) und der Leiterstrukturen (5) in einem Arbeitsgang mindestens folgende Schritte umfasst:
Bereitstellen eines planen oder gebogenen Basiskörpers (2) aus einem dielektrischen Werkstoff wie Glas, Glaskeramik oder Keramik,
Aufbringen von mehreren Schichten aus einbrennbarer Farbe (3), wie Keramik- oder Glasemailfarbe, auf die Rückseite des Basiskörpers (2),
Aufbringen mindestens einer Schicht von Leiterstrukturen aus einbrennbarer Leitpaste (5) auf die Rückseite des Basiskörpers (2) oder die Farbe (3), wobei die Leiterstrukturen mindestens ein Sensorelement umfassen und zur Aufnahme von mindestens einem elektronischen Bauteil (6) ausgebildet sind.

8. Verfahren zur Herstellung eines Bedienpanels (1), das folgende Schritte umfasst:
Bereitstellen eines planen oder gebogenen Basiskörpers (2) aus einem dielektrischen Werkstoff wie Glas, Glaskeramik oder Keramik,
Aufbringen von mehreren Schichten aus einbrennbarer Farbe (3), wie Keramik- oder Glasemailfarbe, auf die Rückseite des Basiskörpers (2),
Aufbringen mindestens einer Schicht von Leiterstrukturen aus einbrennbarer Leitpaste (5) auf die Rückseite des Basiskörpers (2) oder die Farbe (3), wobei die Farbe (3) und die Leitpaste (5) im Wesentlichen die gleiche Einbrenntemperatur haben und die Leiterstrukturen mindestens ein Sensorelement umfassen und zur Aufnahme von mindestens einem elektronischen Bauteil (6) ausgebildet sind,
Einbrennen der Farbschichten (3) und der Leiterstrukturen (5) in einem Arbeitsgang.

9. Verfahren nach Anspruch 8, **dadurch gekennzeichnet, dass** das Einbrennen der mindestens Farbschichten (3) und der Leiterstrukturen (5) in einem Temperaturbereich von 600 bis 700 °C erfolgt.

10. Verfahren nach einem der Ansprüche 8 oder 9, **dadurch gekennzeichnet, dass** das Einbrennen der Farbschichten (3) und der Leiterstrukturen (5) bei einer Temperatur von etwa 620°C erfolgt.

11. Verfahren nach einem der Ansprüche 8 bis 10, **dadurch gekennzeichnet, dass** das Aufbringen der Farbschichten (3) und der Leiterstrukturen (5) im Siebdruckverfahren erfolgt.

12. Verfahren nach einem der Ansprüche 8 bis 11, **dadurch gekennzeichnet, dass** nach dem Aufbringen der Farbschichten (3) und/oder der Leitpastenschichten (5) jeweils ein Zwischentrockenschritt folgt.

13. Verfahren nach einem der Ansprüche 8 bis 11, **dadurch gekennzeichnet, dass** mindestens ein elektronisches Bauteil (6) auf der Rückseite des Basiskörpers (2) angebracht wird.

## Claims

1. Control panel (1) with a planar or curved base body (2) made of dielectric material like glass, glass ceramics or ceramics, which is printed on the rear side with at least one layer of paint (3) that can be fired, like vitreous enamel or ceramic paint, and at least one layer of conductive structures (5) made of conductive paste that can be fired, whereby the conductive structures (5) are formed to accommodate at least one electronic component (6), **characterized in that** several layers of paint that can be fired are applied to the base body (2), the control panel (1) is obtainable by firing of the paint (3) and the conductive paste (5) in one production step, whereby the paint (3) and the conductive paste (5) have essentially the same firing temperature, and the conductive structures (5) comprise at least one sensor element.

2. Control panel (1) according to claim 1, **characterized in that** the firing temperature of the paint (3) and the conductive paste (5) is in the range of 600 to 700°C.

3. Control panel (1) according to claim 1 or 2, **characterized in that** the firing temperature of the paint (3) and the conductive paste (5) is about 620°C.

4. Control panel (1) according to any of claims 1 to 3, **characterized in that** the base body (2) consists of toughened safety glass.

5. Control panel (1) according to any of claims 1 to 4, **characterized in that** at least one electronic component (6) is fixed to the rear side of the base body (2).

6. Control panel (1) according to any of claims 1 to 5, **characterized in that** the conductive structures (5) comprise at least one electronic component (6) like resistors.

7. Control panel (1) according to any of claims 1 to 6, **characterized in that** the control panel (1) is obtainable by a process comprising at least the following steps before firing of at least one layer of paint (3) and the conductive structures (5) in one production step:
supply of a planar or curved base body (2) made of dielectric material like glass, glass ceramics or ceramics,
application of several layers of paint that can be fired (3), like vitreous enamel or ceramic paint, on the rear side of the base body (2),
application of at least one layer of conductive structures made of conductive paste (5) that can be fired on the rear side of the base body (2) or the paint (3), whereby the conductive structures comprise at least one sensor element and are formed to accommodate at least one electronic component (6).

8. Process for producing a control panel (1), comprising the following steps:
supply of a planar or curved base body (2) made of dielectric material like glass, glass ceramics or ceramics,
application of several layers of paint that can be fired (3), like vitreous enamel or ceramic paint, on the rear side of the base body (2),
application of at least one layer of conductive structures made of conductive paste that can be fired (5) on the rear side of the base body (2) or the paint (3), whereby the paint (3) and the conductive paste (5) have essentially the same firing temperature and the conductive structures comprise at least one sensor element and are formed to accommodate at least one electronic component (6),
firing of the layers of paint (3) and the conductive structures (5) in one production step.

9. Process according to claim 8, **characterized in that** the firing of the layers of paint (3) and the conductive structures (5) is carried out in a temperature range of 600 to 700°C.

10. Process according to claim 8 or 9, **characterized in that** the firing of the layers of paint (3) and the conductive structures (5) is carried out at a temperature of about 620°C.

11. Process according to any of claims 8 to 10, **characterized in that** the application of the layers of paint (3) and the conductive structures (5) is carried out by the screen printing method.

12. Process according to any of claims 8 to 11, **characterized in that** the application of the layers of paint (3) and/or the conductive structures (5) is each followed by an intermediate drying step.

13. Process according to any of claims 8 to 11, **characterized in that** at least one electronic component (6) is applied to the rear side of the base body (2).

## Revendications

1. Tableau de commande (1) avec un corps principal (2) plan ou incurvé fait d'une matière diélectrique comme le verre, la vitrocéramique ou la céramique, qui est imprimé au revers d'au moins une couche de couleur à cuire (3) comme de la couleur pour émail ou pour céramique et d'au moins une couche de conducteurs (5) constitués d'une pâte conductrice à cuire, les conducteurs (5) étant formés de manière à accepter au moins un élément électronique (6), **caractérisé en ce que** plusieurs couches de couleur à cuire sont appliquées sur le corps principal (2), le tableau de commande (1) est obtenu par cuisson de la couleur (3) et de la pâte conductrice (5) en une seule opération, la couleur (3) et la pâte conductrice (5) ayant essentiellement la même température de cuisson, et les conducteurs (5) contiennent au moins un capteur.

2. Tableau de commande (1) selon la revendication 1, **caractérisé en ce que** la température de cuisson de la couleur (3) et de la pâte conductrice (5) se situe entre 600 et 700°.

3. Tableau de commande (1) selon la revendication 1 ou 2, **caractérisé en ce que** la température de cuisson de la couleur (3) et de la pâte conductrice (5) est d'environ 620°.

4. Tableau de commande (1) selon l'une des revendications 1 à 3, **caractérisé en ce que** le corps principal (2) est constitué de verre trempé.

5. Tableau de commande (1) selon une des revendications 1 à 4, **caractérisé en ce que** au moins un élément électronique est fixé sur le revers du corps principal (2).

6. Tableau de commande (1) selon une des revendications 1 à 5, **caractérisé en ce que** les conducteurs (5) englobent au moins un composant électronique tel que des résistances.

7. Tableau de commande(1) selon une des revendications 1 à 6, **caractérisé en ce que** le tableau de commande (1) est obtenu par un procédé qui comporte au moins, avant la cuisson d'au moins une couche de couleur (3) et des conducteurs (5) en une seule opération, les étapes suivantes:
préparation d'un corps principal (2) plan ou incurvé fait d'une matière diélectrique telle que le verre, la vitrocéramique ou la céramique,
apport de plusieurs couches de couleur à cuire (3), comme la couleur de céramique ou d'émail, sur le revers du corps principal (2),
apport d'au moins une couche de conducteurs constitués d'une pâte conductrice à cuire (5) sur le revers du corps principal (2) ou sur la couleur (3), les conducteurs englobant au moins un capteur et étant formés de manière à accepter au moins un élément électronique.

8. Procédé pour la fabrication d'un tableau de commande (1), qui comporte les étapes suivantes:
préparation d'un corps principal (2) plan ou incurvé fait d'une matière diélectrique telle que le verre, la vitrocéramique ou la céramique,
apport de plusieurs couches de couleur à cuire (3), comme de la couleur pour émail ou pour céramique sur le revers du corps principal (2),
apport d'au moins une couche de conducteurs constitués de la pâte conductrice à cuire (5) sur le revers du corps principal (2) ou sur la couleur (3), la couleur (3) et la pâte conductrice (5) ayant essentiellement la même température de cuisson et les conducteurs englobant au moins un capteur et étant formés de manière à recevoir au moins un élément électronique (8), cuisson des couches de couleur (3) et des conducteurs en une opération.

9. Procédé selon la revendication 8, **caractérisé en ce que** la cuisson de plusieurs couches de couleur (3) et des conducteurs (5) se déroule à des températures comprises entre 600 et 700°.

10. Procédé selon une des revendications 8 ou 9, **caractérisé en ce que** la cuisson des couches de couleur (3) et des conducteurs (5) se déroule à une température d'environ 620°.

11. Procédé selon une des revendications 8 à 10, **caractérisé en ce que** l'apport des couches de couleur (3) et des conducteurs (5) est réalisé par sérigraphie.

12. Procédé selon une des revendications 8 à 11, **caractérisé en ce qu'**une étape de séchage intermédiaire a lieu après chaque apport des couches de couleur (3) et / ou des couches de pâte conductrice (5).

13. Procédé selon une des revendications 8 à 11, **caractérisé en ce qu'**au moins un élément électronique (6) est apposé au revers du corps principal (2).
